# FASCICULE DE BREVET EUROPEEN

(11) **EP 3 417 322 B1**
(45) Date de publication et mention de la délivrance du brevet: **21.06.2023**
(21) Numéro de dépôt: 17704512.7
(22) Date de dépôt: 16.02.2017
(51) Int. Cl.: G02B 6/00, H01S 3/063, H01L 21/3115, H01L 21/02, G02B 6/12, H01S 5/20, H01S 5/323

(54) **PROCÉDÉ DE FABRICATION D'AU MOINS UNE STRUCTURE SEMI-CONDUCTRICE PRÉSENTANT UN EMPILEMENT D'UNE OU DE PLUSIEURS COUCHES D'ARSÉNIURE DE GALLIUM-ALUMINIUM**
VERFAHREN ZUR HERSTELLUNG VON MINDESTENS EINER HALBLEITENDEN STRUKTUR MIT EINEM STAPEL AUS EINER ODER MEHREREN ALUMINIUMGALLIUMARSENIDSCHICHTEN
METHOD FOR MANUFACTURING AT LEAST ONE SEMICONDUCTING STRUCTURE COMPRISING A STACK OF ONE OR MORE ALUMINIUM GALLIUM ARSENIDE LAYERS

(30) Priorité: 16.02.2016 FR 1670043
(43) Date de publication de la demande: 26.12.2018
(73) Titulaire: Université Paris Cité, 75006 Paris (FR); Centre National de la Recherche Scientifique, 75794 Paris Cedex 16 (FR)
(72) Inventeur: LEO, Giuseppe, 94120 Fontenay-sous-Bois (FR); STEPANENKO, Oleksandr, 92800 Puteaux (FR); LEMAITRE, Aristide, 91150 Etampes (FR)
(74) Mandataire: Dennemeyer & Associates S.A.
(86) Numéro de dépôt international: PCT/EP2017/053542
(87) Numéro de publication internationale: WO 2017/140804

(56) Documents cités:
- US-A1- 2008 285 610
- MATSUSHITA T ET AL: "Fabrication of AlGaAs/Alox waveguides with inversion-stacked core structure for higher-order modal-phase matching devices", 2013 CONFERENCE ON LASERS AND ELECTRO-OPTICS PACIFIC RIM (CLEOPR), IEEE, 30 juin 2013 (2013-06-30), pages 1-2, XP032482003, DOI: 10.1109/CLEOPR.2013.6600158
- SCACCABAROZZI L ET AL: "ENHANCED SECOND-HARMONIC GENERATION IN ALGAAS/ALXOY TIGHTLY CONFINING WAVEGUIDES AND RESONANT CAVITIES", OPTICS LETTERS, OPTICAL SOCIETY OF AMERICA, US, vol. 31, no. 24, 15 décembre 2006 (2006-12-15), pages 3626-3628, XP001501732, ISSN: 0146-9592, DOI: 10.1364/OL.31.003626

## Description

### DOMAINE DE L'INVENTION

La présente invention concerne un procédé de fabrication d'un empilement monolithique d'au moins une structure semi-conductrice présentant une ou plusieurs couches semi-conductrices d'AlₓᵢGa₁₋ₓᵢAs sur une couche électriquement isolante.

### ETAT DE LA TECHNIQUE

Bénéficiant d'un demi-siècle de développement de la micro-électronique silicium (Si), le système silicium sur isolant (SOI en anglais) s'est désormais affirmé comme la référence pour la photonique intégrée. Il s'agit d'une technologie générique permettant une large gamme d'applications sur des gros volumes de dispositifs. Sa brique de base est constituée par un guide d'onde SOI, qui est fortement confinant du fait du saut d'indice très élevé entre le coeur en Si et le substrat en SiO₂.

Les perspectives annoncées du système SOI sont une intégration monolithique avec la plateforme CMOS pour la partie électronique, et une intégration hybride avec la plateforme InP pour la partie lasers. La nécessité de cette hybridation est due au gap indirect Si, qui n'est pas un matériau laser, mais deux autres limitations affectent cet élément du IV groupe : il souffre d'absorption à deux photons (TPA) aux longueurs d'ondes télécoms (à cause de son gap de 1,1 eV), et il est dépourvu de non-linéarité d'ordre deux (à cause de sa symétrique cristalline).

Pour dépasser ces limitations, une plateforme photonique intégrée AlGaAs sur isolant serait souhaitable, mais jusqu'à présent son développement est freiné d'une part par la complexité technologique de l'hybridation AlGaAs sur Si réalisée par *wafer bonding* et, d'autre part, par l'inefficacité du processus d'oxydation latérale sélective de couches épaisses d'AlGaAs en couches d'AlOx faisant office de substrat optique.

En effet, alors que ce processus est bien maîtrisé pour l'oxydation de couches d'AlOx de quelques dizaines de nanomètres d'épaisseur dites couches minces, son application à l'oxydation de couches d'AlOx beaucoup plus épaisses, d'au moins quelques centaines de nanomètres d'épaisseur, nécessite une nouvelle stratégie, pour éviter que les contraintes induites par la contraction de l'AlAs pendant l'oxydation donnent lieu à des défauts et à des pertes optiques, voire à la délamination des différentes couches, qui n'est pas connue avec succès à ce jour.

Dans les dernières années, les travaux de trois groupes de recherches particulièrement actifs sur la question, témoignent de l'intérêt vers les substrats optiques à faible indice pour la photonique non linéaire AlGaAs.

Deux d'entre eux ont fabriqué et caractérisé des guides d'ondes comportant un cœur de GaAs sur une couche épaisse d'AlOx.

D'abord à Stanford, à travers la publication L. Scaccabarozzi, M. Fejer, Y. Huo, S. Fan, X. Yu et J. Harris, "Enhanced second-harmonie génération in AlGaAs/AlxOy tightly confining waveguides and résonant cavities", Optics Lett. 31, 3626 (2006*),* et ensuite à l'Université de Tokyo à travers la publication T.W. Kim, T. Matsushita, T. Kondo, "Phase-matched second-harmonie génération in thin rectangular high-index-contrast AIGaAs waveguides", Appl. Phys. Express 4, 082201 (2011*),* une solution au problème des défauts aux interfaces AlOx/GaAs a été cherchée en ralentissant la cinétique d'oxydation via la diminution du pourcentage d'aluminium (de 98% à 93%) dans les couches d'AlGaAs à oxyder.

En 2013, le groupe japonais a annoncé la fabrication d'un autre guide AlOx/ Al_{0,5}Ga_{0,5}As, avec le substrat d'oxyde obtenu à partir d'Al_{0,8}Ga_{0,2}As à travers la publication T. Matsushita, Y. Nakamura, S. Matsumoto, T. Onda, I. Shoji, and T. Kondo, "Fabrication of AlGaAs/Alox waveguides with inversion-stacked core structure for higher-order modal-phase matching devices", 2013 IEEE Conf. on Lasers and Electro-Optics Pacific Rim (CLEO-PR), Kyoto, June 30 2013-July 4 2013*.* Mais là également ce qui a été privilégié c'est de ralentir la cinétique d'oxydation via la diminution du pourcentage d'aluminium (80%) dans les couches d'AlGaAs à oxyder.

La publication MATSUSHITA T ET AL, "Fabrication of AlGaAs/Alox waveguides with inversion-stacked core structure for higher-order modal-phase matching devices", 2013 CONFERENCE ON LASERS AND ELECTRO-OPTICS PACIFIC RIM (CLEOPR), IEEE, (20130630), décrit un procédé de fabrication d'au moins une structure semi-conductrice présentant un empilement de n couches semi-conductrices d'Arséniure de Gallium-Aluminium AlxiGa1-xiAs, n étant un entier supérieur ou égal à 1 (et 1 ≤ i ≤ n), pour lesquelles xi est inférieur à 0.8, sur une couche d'AlxGa1-xAs oxydé isolante, qui a une épaisseur donnée e suffisante pour confiner la lumière dans la structure semi-conductrice, par réflexion totale interne et qui sert de substrat optique à la structure semi-conductrice. Suivant cette publication , des guides d'ondes AlGaAs sont réalisés par wafer bonding et disposés entre 2 couches d'Alox, et il est réalisé par épitaxie deux ensembles identiques=structure semi-conductrice puis couche à fraction d'aluminium donnée ; puis « waferbonding » des 2 ensembles en renversant l'une des 2 ensembles sur l'autre et en collant les parties qui ne vont pas être oxydées (fraction d'aluminium x égale à 0.5); puis oxydation de la couche ayant la fraction d'aluminium x=0.8.

Aucune de ces publications ne permet d'obtenir des couches d'AlOx épaisses ayant une épaisseur supérieure à plusieurs centaines de nanomètres avec des valeurs de pertes inférieures à 20 dB/cm.

### EXPOSE DE L'INVENTION

Selon l'invention, un procédé de fabrication d'au moins une structure semi-conductrice présentant un empilement de n couches semi-conductrices d'Arséniure de Gallium-Aluminium AlₓᵢGa₁₋ₓᵢAs, n étant un entier supérieur ou égal à 1 (et 1 ≤ i ≤ n), pour lesquelles xi est inférieur à 0.8, sur une couche d'AlₓGa₁₋ₓAs oxydé isolante, qui a une épaisseur donnée e suffisante pour confiner la lumière dans la structure semi-conductrice, par réflexion totale interne et qui sert de substrat optique à la structure semi-conductrice, e étant supérieure à 200 nm et inférieure à 10 micromètres est réalisé, le procédé comprenant les étapes de la revendication 1.

Selon l'invention, le procédé de fabrication comprend les étapes suivantes :
- dans une première étape (i), sur un substrat (4) de GaAs, croissance par épitaxie :
   *d'une couche semi-conductrice AlₓGa₁₋ₓAs (3a), ayant une épaisseur e=e0+ e1+ e2, et comprenant une partie d' épaisseur e0, une partie d'épaisseur e1 et une partie d' épaisseur e2, la partie d'épaisseur e0 ayant une fraction molaire en aluminium x=x0 donnée supérieure ou égale à 0.90, la partie d'épaisseur e0 étant située entre la partie d'épaisseur e1 et la partie d'épaisseur e2,
   *puis d'une ou plusieurs couches (2) semi-conductrices AlₓᵢGa₁₋ₓᵢAs,

   la croissance par épitaxie de la première étape (i) étant réalisée de sorte à ce que la fraction molaire d'aluminium x de la couche semi-conductrice (3a) d'AlₓGa₁₋ₓAs diminue, à partir de l'épaisseur e0, graduellement selon une variation progressive et continue:
      dans l'épaisseur e1, suivant un premier sens, selon un premier gradient d'aluminium (G1), de la fraction molaire en aluminium x0 donnée de l'épaisseur e0 jusqu'à la fraction molaire d'aluminium x=0 du substrat (4) de GaAs, e1 étant en contact avec le substrat (4) et l'épaisseur e0, et
   dans l'épaisseur e2, suivant un deuxième sens, opposé au premier sens, selon un deuxième gradient d'aluminium (G2), de la fraction molaire en aluminium x0 donnée de l'épaisseur e0 jusqu'à la fraction molaire d'aluminium x=x1, avec x1 fraction molaire d'une première couche semi-conductrice Alₓ₁Ga₁₋ₓ₁As de l'empilement de n couches (2) semi-conductrices d'Arséniure de Gallium-Aluminium AlₓᵢGa₁₋ₓᵢAs, adjacente à la couche semi-conductrice AlₓGa₁₋ₓAs (3a), e2 étant en contact avec l' l'épaisseur e0 et la couche Alₓ₁Ga₁₋ₓ₁As ;
- dans une deuxième étape (ii),
   réalisation de la structure (1) semi-conductrice de couches (2) semi-conductrices d'AlₓᵢGa₁₋ₓᵢAs, par lithographie et gravure, et
   suppression par lithographie et gravure de l'épaisseur e2 à gradient d'aluminium G2 de la couche semi-conductrice d'AlₓGa₁₋ₓAs (3a) sauf sous la structure (1) semi-conductrice;
- dans une troisième étape (iii), oxydation latérale de la couche semi-conductrice (3a) d'AlₓGa₁₋ₓAs pour obtenir la couche (3b) d'AlₓGa₁₋ₓAs oxydé,
les couches semi-conductrices d'AlₓᵢGa₁₋ₓᵢAs de la structure (1) semi-conductrice, pour lesquelles xi est inférieur à 0.8, n'étant pas oxydées.

La présente invention concerne aussi un dispositif obtenu par le procédé de fabrication défini ci-avant, et comprenant un empilement monolithique avec :
- une structure semi-conductrice ayant une ou plusieurs couches de AlₓᵢGa₁₋ₓᵢAs, i étant un entier supérieur ou égal à 1, sur une couche d'AlOx électriquement isolante, la couche d'AlOx ayant une épaisseur e suffisante pour confiner la lumière dans la structure semi conductrice par réflexion totale interne, cette couche d'AlOx étant en appui sur un substrat de GaAs ;
- la couche d'AlOx présentant une épaisseur jusqu'à plusieurs micromètres;
- une première transition d'oxydation graduelle entre le substrat GaAs et la couche d'AlOx suivant une épaisseur e1;
- une deuxième transition d'oxydation graduelle, suivant une épaisseur e2, entre la couche d'AlOx et une première couche semi-conductrice Alₓ₁Ga₁₋ₓ₁As adjacente à la couche d'AlOx.

La première transition d'oxydation graduelle et la deuxième transition d'oxydation graduelle correspondent au premier gradient d'aluminium G1 et au deuxième gradient G2 de la couche semi-conductrice AlₓGa₁₋ₓAs une fois cette couche oxydée.

Ce terme de transition d'oxydation graduelle signifie que :
- la couche e1 est oxydée de façon graduelle à partir de la couche oxydée ayant une épaisseur donnée e0 avec une teneur en aluminium x0, l'oxydation de la couche e1 étant la plus forte pour la partie de la couche e1 la plus proche de la couche oxydée e0 et la plus faible pour la partie de la couche e1 la plus éloignée de la couche oxydée e0 (la plus proche du substrat GaAs ) ;
- la couche e2 est oxydée de façon graduelle à partir de la couche oxydée ayant une épaisseur donnée e0 avec une teneur en aluminium x0, l'oxydation de la couche e2 étant la plus forte pour la partie de la couche e2 la plus proche de la couche oxydée e0 et la plus faible pour la partie de la couche e2 la plus éloignée de la couche oxydée e0 (la plus proche de la structure semi-conductrice 1 de couches d'AlₓᵢGa₁₋ₓᵢAs) ;

Ainsi l'invention permet une transition dite douce entre le substrat amorphe oxydé d'AlOx et la structure cristalline supérieure faite de couches de AlₓᵢGa₁₋ₓᵢAs, ces couches d'AlxiGa1-xiAs étant pour un certain nombre non oxydées afin de servir de guide d'onde de haute qualité optique.

### DESCRIPTION DES FIGURES

D'autres objectifs, caractéristiques et avantages sortiront de la description détaillée qui suit en référence aux dessins donnés à titre illustratif et non limitatif parmi lesquels :
- les figures 1a à 1d représentent un mode de réalisation possible par le procédé de l'invention avec une seule couche semi-conductrice sur la couche d'AlOx; il n'a pas été représenté sur la figure 1c la gravure de la couche e2 illustrée sur la figure 1a ;
- les figures 1e à 1h représentent le procédé de l'invention avec plusieurs couches semi conductrices empilées sur la couche d'AlOx;
- la figure 2a représente un laser réalisé par le procédé de l'invention;
- la figure 2b représente le confinement vertical du laser de la figure 2a (ligne continue) et le compare à celui d'un laser standard dépourvu de la couche d'AlOx (ligne pointillée) ;
- la figure 3a représente une vue de dessus d'un micro résonateur à anneau et un guide d'onde couplé à l'anneau et la figure 3b est une photographie au microscope électronique d'une telle structure qui a été réalisée ;
- la figure 4a représente une vue en coupe du guide d'onde monolithique de la figure 2 réalisé par un procédé de l'état de l'art ;
- la figure 4b représente l'intensité du mode du guide de la figure 4a ;
- la figure 4c représente le couplage critique entre l'anneau et le guide d'onde obtenu avec la structure de la figure 4a ;
- la figure 5a représente une vue en coupe du guide d'onde de la figure 3 réalisé par le procédé selon l'invention ;
- la figure 5b représente l'intensité du mode du guide de la figure 5a ;
- la figure 5c représente le couplage critique entre l'anneau et le guide d'onde obtenu avec la structure de la figure 5a ;
- les figures 6a à 6c représentent les conditions typiques de l'oxydation d'AlₓGa₁₋ₓAs, comme décrit dans la publication `J.H. Kim et al., Applied Physics Letters 69, 3357 (1996)'.

### DESCRIPTION DETAILLEE DE L'INVENTION

L'invention est un procédé de construction d'une structure 1 constituée de l'empilement d'une ou plusieurs couches semi-conductrices d'arséniure de gallium-aluminium (AlₓᵢGa₁₋ₓᵢAs) sur une couche d'oxyde d'aluminium (AIOx) de plusieurs micromètres d'épaisseur, le tout étant monolithique sur un wafer d'arséniure de gallium (GaAs).

« AIOx » désigne le matériau constituant la couche d'arséniure de gallium-aluminium oxydé, contient des atomes d'aluminium et d'oxygène, et éventuellement quelques atomes de galium et d'arsenic (surtout dans les couches d'oxydation graduelle), et peut s'appeler « AlₓGa₁₋ₓAs oxydé ».

A l'instar du système silicium sur isolant (SOI), le fort saut d'indice de réfraction entre la couche d'AlOx et l'empilement des couches d'AlₓᵢGa₁₋ₓᵢAs assure le confinement de la lumière dans des micro/nano-guides ou des micro/nano-résonateurs optiques faiblement gravés.

Par rapport à la plateforme SOI, ladite structure 1 présente trois avantages majeurs, liés à des propriétés fondamentales de l'AlGaAs : i) l'absence d'absorption à deux photons aux longueurs d'onde des communications optiques et en particulier à 1,55 µm ; ii) la possibilité d'émission laser ; iii) une non linéarité optique d'ordre deux.

La spécificité de l'invention tient aux paramètres de fabrication, allant de la croissance épitaxiale d'une hétérostructure 1 jusqu'à l'oxydation sélective de certaines de ses couches AIGaAs et pas de toutes, le procédé permettant de sélectionner les couches que l'on souhaite oxyder par leur concentration en Al (celles ayant une forte concentration en Aluminium).

Cette nouvelle technologie AIGaAs sur isolant ouvre la voie à une photonique non-linéaire sur puce semi-conductrice monolithique, pour des nombreuses applications télécoms et environnementales.

L'invention est un procédé de fabrication d'au moins une structure 1 semi-conductrice supérieure présentant un empilement d'une ou plusieurs couches 2 de AlₓᵢGa₁₋ₓᵢAs, i étant un entier supérieur ou égal à 1, sur une couche 3b d'AIOx électriquement isolante, la couche 3b d'AlOx ayant une épaisseur e suffisante pour confiner la lumière dans la structure 1 semi-conductrice par réflexion totale interne et servir donc de substrat optique à la couche semi-conductrice.

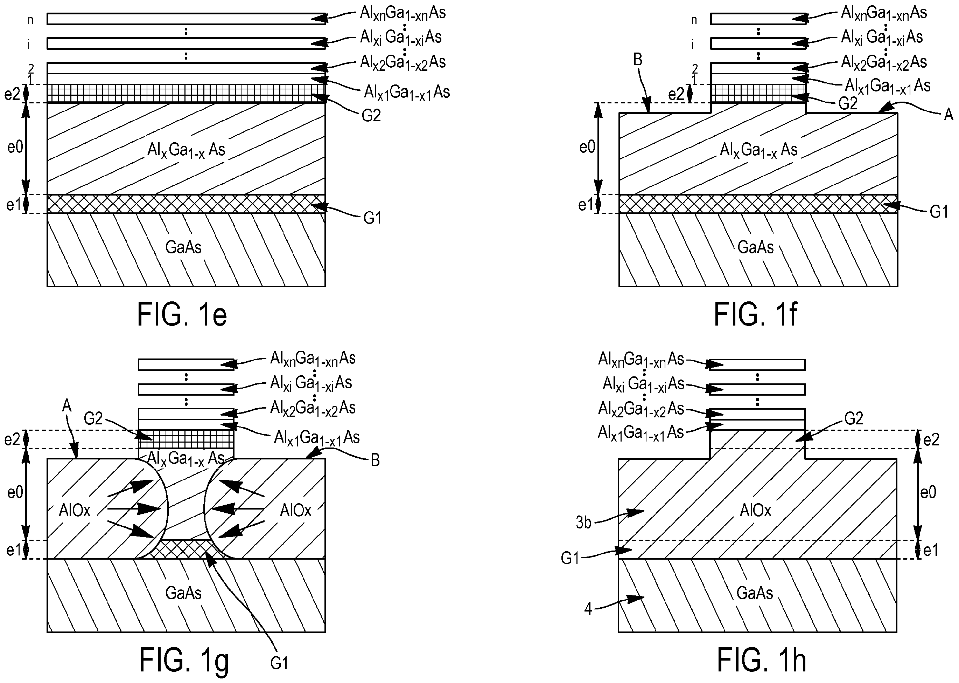

Plus précisément, le procédé illustré sur les figures 1e à 1h, comprend les étapes suivantes :
- dans une première étape (i), à partir d'un substrat 4 de GaAs, croissance par épitaxie : d'une couche semi-conductrice AlₓGa₁₋ₓAs avec une fraction molaire en aluminium x0 supérieure ou égale à 0.90 constante sur une épaisseur e0 donnée, puis d'une ou plusieurs couches semi-conductrices AlₓᵢGa₁₋ₓᵢAs, de sorte à ce que la fraction molaire d'aluminium x de la couche semi-conductrice AlₓGa₁₋ₓAs diminue graduellement depuis l'épaisseur e0 :
   suivant une épaisseur e1, vers le bas (suivant un premier sens), selon un gradient d'aluminium G1, de x0 jusqu'à la fraction molaire x=0 du substrat 4 de GaAs, la fraction molaire d'aluminium x passant donc graduellement de x0 supérieure ou égale à 0.90 à x=0 ; et
   suivant une épaisseur e2, vers le haut (suivant un second sens opposé au premier sens), selon un gradient d'aluminium G2, de x0 jusqu'à la fraction molaire x=x1 d'une première couche semi-conductrice Alₓ₁Ga₁₋ₓ₁As de la structure 1 semi-conductrice adjacente à la couche 3b d'AlₓGa₁₋ₓAs, la fraction molaire d'aluminium x passant donc graduellement de x0 supérieure ou égale à 0.90 à x=x1 ;
- dans une deuxième étape (ii), réalisation de la structure 1 semi-conductrice de couches 2 de AlₓᵢGa₁₋ₓᵢAs par lithographie et gravure qui permettent de supprimer les couches d'AlₓᵢGa₁₋ₓᵢAs sauf au niveau de la structure 1, et suppression par lithographie et gravure de l'épaisseur e2 à gradient d'aluminium G2 de la couche semi-conductrice AlₓGa₁₋ₓAs sauf l'épaisseur e2 située sous la structure 1; la suppression de l'épaisseur e2 favorise beaucoup l'oxydation par la surface de la couche très riche en aluminium AlₓGa₁₋ₓAs et donc la cinétique d'oxydation ;
- dans une troisième étape (iii), oxydation de la couche semi-conductrice AlₓGa₁₋ₓAs pour obtenir la couche 3b d'AIOx.

La figure 1e montre les couches AlₓᵢGa₁₋ₓᵢAs et AlₓGa₁₋ₓAs formées juste après l'épitaxie.

La figure 1f montre les couches AlₓᵢGa₁₋ₓᵢAs et AlₓGa₁₋ₓAs juste après la lithographie et gravure de ces couches.

La figure 1g montre la structure pendant l'oxydation sélective de la couche d'AlₓGa₁₋ₓAs (notamment les fronts d'oxydation) et éventuellement des couches d'AlₓᵢGa₁₋ₓᵢAs oxydé (ou AlOx) si xi supérieur à 0.9.

La figure 1h montre les couches juste après l'oxydation sélective de la couche de substrat AlₓGa₁₋ₓAs devenu AlₓGa₁₋ₓAs oxidé (ou AlOx). Aussi les couches d'AlₓᵢGa₁₋ₓᵢAs seront oxydées si xi supérieur à 0.9.

Il est également à noter qu'il peut être aussi supprimé, par lithographie et gravure, une petite épaisseur de l'épaisseur donnée e0 de la couche semi-conductrice AlₓGa₁₋ₓAs, sauf la petite épaisseur située sous la structure 1. On veut par-là s'assurer que toute l'épaisseur e2 est supprimée sauf sous la structure 1, pour permettre d'obtenir une oxydation rapide et de qualité de la couche AlₓGa₁₋ₓAs, ce qui est permis par les grandes surfaces latérales nommées A et B.

La lithographie et la gravure sont réalisées pour que les deux grandes surfaces latérales d'AlₓGa₁₋ₓAs, nommées A et B, ici horizontales, à gauche et à droite de la structure 1, soient disponibles à l'air pour permettre une oxydation importante, les fronts d'oxydation commençant à se propager par ces surfaces latérales A et B de la couche d'AlₓGa₁₋ₓAs pour ensuite se propager latéralement à l'intérieur de la couche AlₓGa₁₋ₓAs.

Ces fronts d'oxydation se propagent dans les couches ayant les grandes teneurs en aluminium pour aller ensuite vers les gradients G1 et G2 verticalement par l'épaisseur e0.

L'oxydation est bien plus importante latéralement par ces surfaces latérales A et B, que directement par les hauteurs verticales des gradients G1 et G2 à l'air libre, au vu de l'étendue de ces surfaces latérales A et B, et des teneurs en aluminium nettement plus faibles dans ces hauteurs que la couche d'épaisseur e0 d'AlₓGa₁₋ₓAs.

Avantageusement, la couche semi-conductrice 3a d'AlₓGa₁₋ₓAs peut avoir une épaisseur donnée e de quelques centaines de nanomètres jusqu'à plusieurs micromètres.

L'épaisseur e donnée est égale à e=e1+e0+e2.

Cette couche d'AlₓGa₁₋ₓAs, qui est dite épaisse par opposition aux couches dites minces qui font quelques dizaines de nanomètres, sert de substrat optique à la structure 1 semi-conductrice.

Elle présente une épaisseur supérieure à au moins 200 nm.

Elle présente une épaisseur e inférieure à 10 micromètres, ou à 5 micromètres en fonction des applications et des structures semi-conductrices envisagées et du confinement de la lumière souhaitée.

L'invention permet d'avoir pour un certain nombre d'applications des couches d'AIOx inférieures au micromètre.

Le premier gradient d'aluminium G1 (variation progressive et continue de la fraction d'aluminium G1) peut être réalisé sur une épaisseur entre 80 et 100 nm pour permettre d'améliorer la tenue mécanique de la couche 3b d'AIOx obtenue par oxydation de la couche semi-conductrice 3a d'AlₓGa₁₋ₓAs.

Le deuxième gradient d'aluminium G2 (variation progressive et continue de la fraction d'aluminium G1) peut être réalisé sur une épaisseur entre 80 et 100 nm pour permettre d'améliorer la tenue mécanique de la couche 3b d'AIOx obtenue par oxydation de la couche 3a d'AlₓGa₁₋ₓAs et le confinement des ondes dans la structure 1 semi-conductrice de couches 2 d'AlₓᵢGa₁₋ₓᵢ As.

Ces gradients d'aluminium G1, G2 permettent d'éviter que les contraintes induites par la contraction de l'AlₓGa₁₋ₓAs pendant l'oxydation, donnent lieu à des défauts et à des pertes optiques, voire à la délamination des différentes couches.

De façon avantageuse aussi, le gradient G2 atténue la diffusion des ondes à la surface de contact entre la première couche Alₓ₁Ga₁₋ₓ₁As et la couche AIOx dont les indices optiques sont différents. L'évolution progressive de l'indice optique lié à l'évolution progressive de la teneur en aluminium jusqu'à la couche 3b d'AIOx suivant le gradient G2, permet un meilleur confinement de la lumière dans la structure 1 semi-conductrice AlₓᵢGa₁₋ₓᵢ As (avec i allant de 1 à n).

Par oxydation, une ou plusieurs couches d'AlOx peuvent aussi être réalisées dans la structure 1 semi-conductrice AlₓᵢGa₁₋ₓᵢAs, par exemple pour exalter la biréfringence de forme et obtenir l'accord de phase dans le mélange non linéaire entre modes guidés.

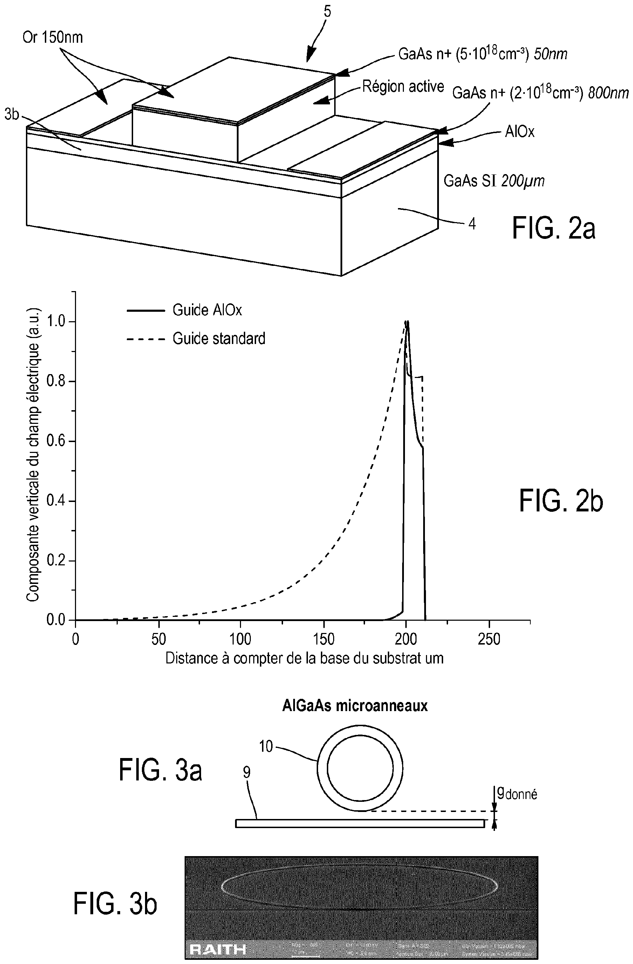

xi est la fraction molaire d'aluminium de l'i-ème couche d'AlₓᵢGa₁₋ₓᵢAs et est compris entre 0 et 1, et pour xi=0 cette couche est GaAs, comme illustré sur la figure 2a.

Avantageusement, dans un mode de réalisation préféré, pour la couche semi-conductrice AlₓGa₁₋ₓAs, la fraction molaire x d'aluminium est égale à 0.98, permettant de conjuguer de façon optimale la vitesse d'oxydation et la tenue mécanique de ladite couche.

En effet, plus la fraction molaire en aluminium x est élevée et plus la cinétique d'oxydation est rapide. Pour x≥0,9, la fraction d'aluminium est dite élevée.

Dans la structure 1 semi-conductrice AlₓᵢGa₁₋ₓᵢAs, xi est inférieur à 0.8, sauf pour des couches 2 d'AlₓᵢGa₁₋ₓᵢAs que l'on souhaite oxyder et pour lesquelles xi≥0.9.

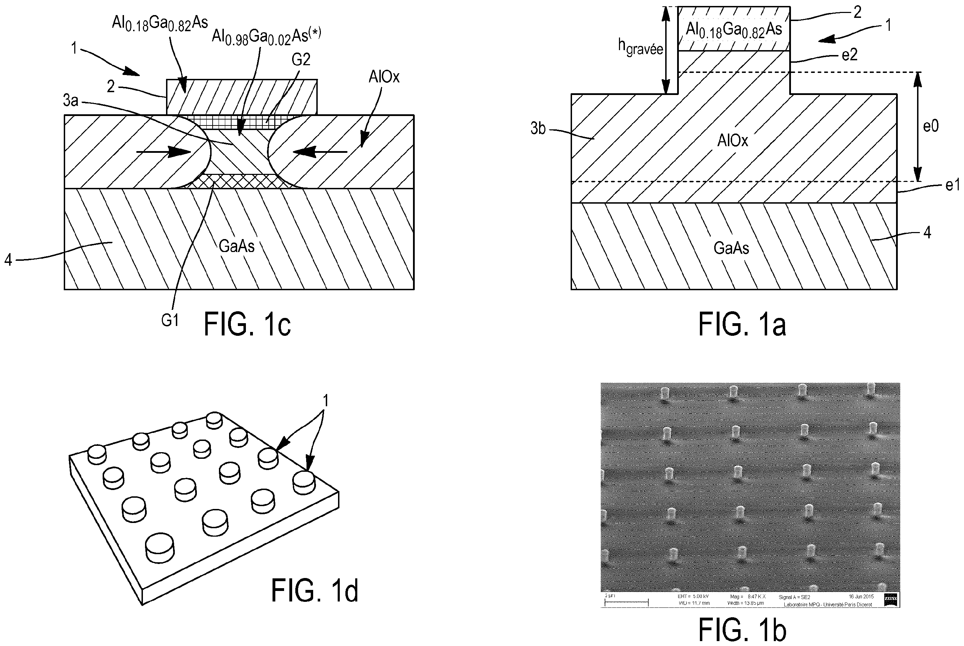

Ici, sur l'exemple illustré sur les figures 1a à 1d, il a été réalisé une structure apte à confiner verticalement la lumière, reposant sur une couche 3b d'AlOx ayant une teneur en aluminium de 0.98.

Il est montré deux fronts d'oxydation avec les deux flèches en sens contraire sur la figure 1c, qui viennent oxyder la couche 3a par deux côtés opposés au moment de la troisième étape iii d'oxydation.

Suite à cette oxydation sélective, il est obtenu la couche d'AIOx isolante sur laquelle repose une structure semi-conductrice 1 ayant des couches d'AlₓᵢGa₁₋ₓᵢAs non oxydées ou cristallines, comme illustré sur la figure 1a.

Il peut être réalisé sur un même substrat GaAs, un certain nombre de structures 1 semi-conductrices AlₓᵢGa₁₋ₓᵢAs de différentes formes ou pas, à distance les unes des autres sur la couche 3b d'AIOx, couplées optiquement ou pas, reposant chacune sur cette couche 3b d'AIOx obtenue par le procédé selon l'invention.

Dans la première étape (i), toute couche semi-conductrice que l'on souhaite oxyder peut être réalisée par un réseau équivalent d'alliages binaires AlAs/GaAs.

La température d'oxydation peut être choisie entre 390°C et 430°C.

Mais en augmentant la teneur en aluminium x0 de la couche principale e0 de la couche AlxGa1-xAs (par exemple x0=0.98), il est possible de diminuer la température d'oxydation et de choisir une température égale ou inférieure. 390° C.

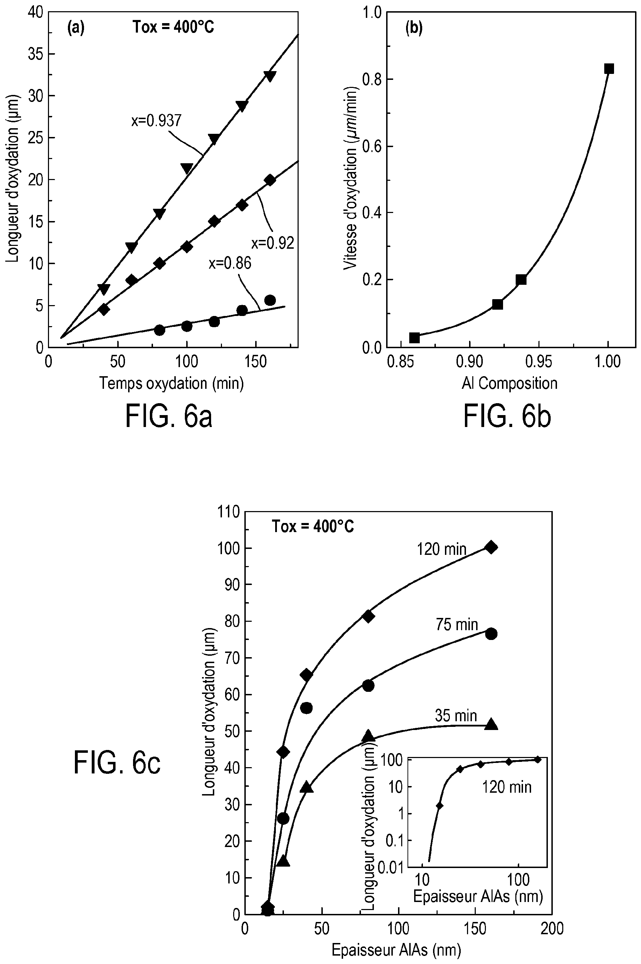

La figure 6a représente la longueur d'oxydation comme une fonction de l'épaisseur AlAs à différents moments de l'oxydation à 400°C, montrant une forte dépendance de l'épaisseur AlAs pour des valeurs plus petites que 80nm. La fenêtre correspondant à 120 minutes d'oxydation montre une épaisseur minimum d'une couche AlAs à oxyder d'un peu près 11nm.

La figure 6c représente l'oxydation latérale humide de couches d'un micromètre d'épaisseur. Sur la figure 6a, la longueur d'oxydation en fonction du temps d'oxydation indique la relation linéaire entre ces deux grandeurs. Sur la figure 6b, la vitesse d'oxydation en fonction de la composition d'aluminium montre un grand degré de sélectivité dans l'oxydation.

La couche semi-conductrice AlₓGa₁₋ₓAs est protégée sous vide de l'oxydation de l'air ambiant, entre la deuxième étape (ii) et la troisième étape (iii).

L'oxydation a lieu après une durée d'exposition à l'air inférieure à une heure après la deuxième étape (ii).

L'invention concerne aussi un dispositif obtenu par le procédé de fabrication ci-avant illustré sur la figure 1a.

Le dispositif comprend un empilement monolithique avec :
- une structure 1 semi-conductrice ayant une ou n couches 2 de AlₓᵢGa₁₋ₓᵢAs, i étant un entier supérieur ou égal à 1 sur une couche 3b d'AIOx électriquement isolante, la couche 3b d'AlOx ayant une épaisseur e suffisante pour confiner la lumière dans la structure 1 semi-conductrice par réflexion totale interne, cette couche 3b d'AlOx étant en appui sur un substrat GaAs ;
- la couche 3b d'AlOx présentant une épaisseur donnée e jusqu'à plusieurs micromètres ;
- une transition d'oxydation graduelle entre le substrat GaAs et la couche 3b d'AIOx suivant une épaisseur e1, le degré d'oxydation diminuant dans l'épaisseur e1 graduellement à partir la couche d'AlₓGa₁₋ₓ oxydé, d'épaisseur donnée e0, vers le substrat 4 de GaAs;
- une transition d'oxydation graduelle suivant une épaisseur e2, entre la couche AIOx et une première couche semi-conductrice Alₓ₁Ga₁₋ₓ₁As adjacente à la couche 3b d'AIOx, le degré d'oxydation diminuant dans l'épaisseur e2 graduellement à partir la couche d'AlₓGa₁₋ₓ oxydé, d'épaisseur donnée e0, vers le substrat 4 de GaAs.

La structure 1 semi-conductrice peut présenter également une ou plusieurs couches d'AlₓᵢGa₁₋ₓᵢAs oxydé (AIOx) après l'oxydation de la troisième étape (iii), ces couches d'AlₓᵢGa₁₋ₓᵢAs présentant une teneur en aluminium xi ≥ 0,90.

L'invention permet par une cinétique d'oxydation, des gradients d'aluminium appropriés, et une oxydation latérale et par la surface : de réaliser une oxydation sélective des couches d'AlₓGa₁₋ₓAs et AlₓᵢGa₁₋ₓᵢAs superposées, pour obtenir une structure semi-conductrice empilée sur une couche isolante d'AIOx et pouvant présenter des couches d'AlₓᵢGa₁₋ₓᵢAs non oxydé, et des couches AlₓᵢGa₁₋ₓᵢAs oxydé, sans pour autant de délamination de ces couches.

De surcroit, le saut d'indice de réfraction étant grand entre la couche d'AlₓGa₁₋ₓAs oxydé et la structure 1, la structure 1 peut être faiblement gravée mais un fort confinement de la lumière dans son volume, permettant par exemple des couplages optiques avec d'autres structures situées à proximité (à des distances inférieures à 100 nm par exemple), comme représenté sur les figures 3a et 3b par l'exemple du couplage du guide d'onde avec l'anneau.

La structure 1 semi-conductrice peut être une micro- ou nano-structure optique active ou passive, tel un guide d'onde, un résonateur, une antenne diélectrique, ou une combinaison d'une ou plusieurs de chacune de ces structures, éventuellement incorporant un laser ou un capteur optique à semi-conducteur.

Par exemple, la structure 1 semi-conductrice a la forme d'une ou de plusieurs antennes diélectriques qui rayonnent avec un signal de second harmonique, de hauteur et de largeur inférieures à la longueur d'onde de la pompe (1,55 µm), comme illustré sur la figure 1b.

Le laser à cascade quantique illustré sur la figure 2a est aussi réalisé par le procédé selon l'invention.
Il est observé que le champ électrique est confiné dans la région active comme l'illustre le graphique de la figure 2b, donc par une couche métallique en haut et par une couche de GaAs fortement dopé n en bas.

La présence d'une couche 3b d'AIOx en dessous de cette couche fortement dopée permet à cette dernière de confiner le mode laser de façon comparable au cas d'un laser « double métal », mais sans passer par une étape de *wafer bonding.*

Il a été également représenté dans la figure 2b le confinement vertical pour un dispositif « simple métal » de l'état de l'art et un dispositif réalisé par le procédé selon l'invention.

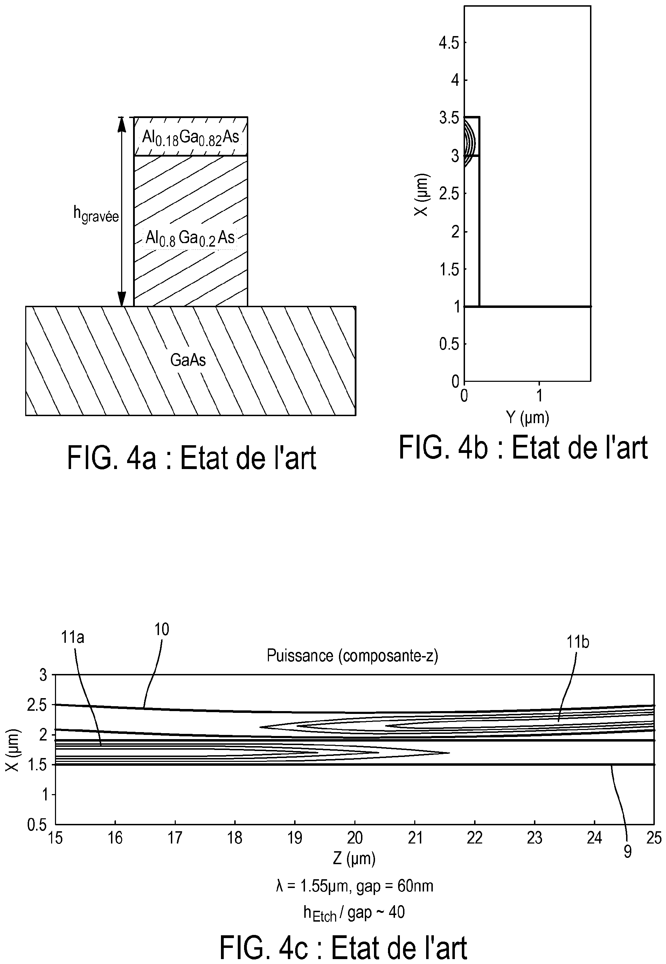

Il est aussi montré sur la figure 4a, que dans un guide d'onde monolithique classique sans substrat d'oxyde, une couche semi-conductrice (Al₈₀Ga₂₀As) d'épaisseur (hauteur) supérieure ou égale à 2 µm est nécessaire pour confiner un mode à une longueur d'onde de 1,55 µm dans le coeur d'Al₁₈Ga₈₂As. Dans un microsystème photonique constitué d'un guide d'onde et d'un micro-anneau, les conditions optimales de couplage (le flux de puissance de droite 11a correspondant au flux de puissance de gauche 11b) imposent un écart g_{donné} ou gap guide-anneau de 60 nm pour une longueur d'onde de 1,55 µm, soit un rapport hauteur de gravure (h_{Etch})/gap de l'ordre de 40. De telles contraintes sont aujourd'hui très fortes pour les techniques de gravure (lithographie à faisceau d'électrons).

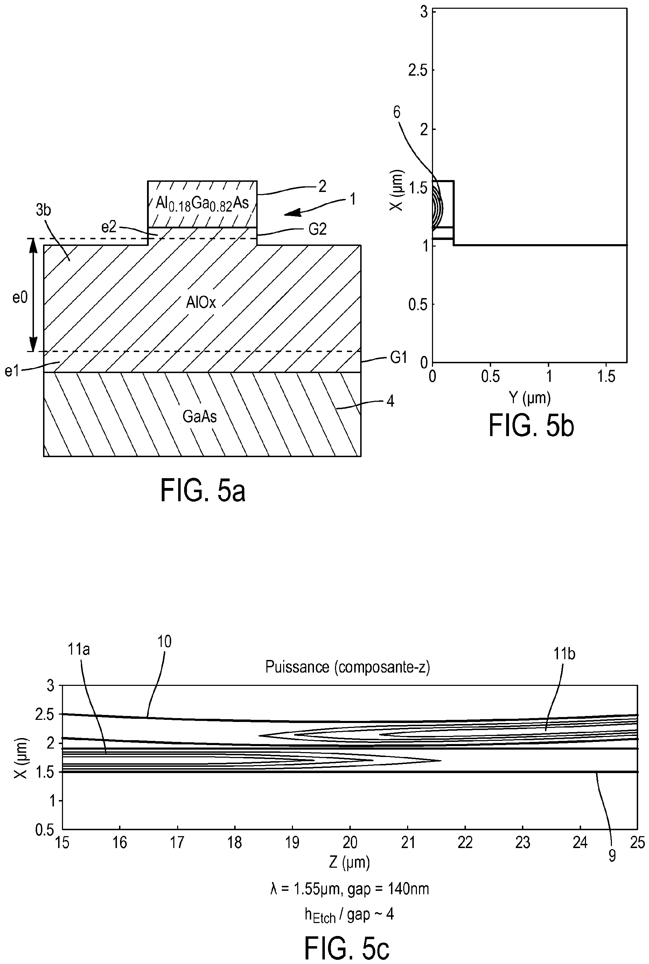

Au contraire avec le dispositif selon l'invention et comme illustré sur la figure 5c, l'écart g_{donné} ou *gap* entre le guide d'ondes et l'anneau peut être plus grand et le rapport h_{Etch} / gap égal environ à 4.

Grâce à l'invention, on peut ainsi réaliser deux structures 1 (nommées 9 et 10 sur la figure 3a), couplées optiquement, ayant une ou plusieurs couches semi-conductrices d'AlₓᵢGa₁₋ₓᵢAs chacune, gravées avec une hauteur de gravure h_{donnée} et un écart g_{donné} entre les deux structures gravées (1), et dans lequel le rapport entre h_{donnée} / g_{donné} est inférieur à 10, pour un écart g_{donné} inférieur à 100 nm.

En effet, comme l'indice de réfraction de la couche d'AlₓGa₁₋ₓAs oxydé (ou AlOx) est très faible (par exemple inférieure 2 et ici égal à environ 1.6), le saut d'indice de réfraction est grand entre la couche d'AlₓGa₁₋ₓAs oxydé (ou AlOx) avec la structure 1 permettant à la lumière d'être bien confinée dans cette dernière et de ne pas déborder dans la couche d'AlₓGa₁₋ₓAs oxydé (ou AlOx).

Grâce au procédé selon l'invention, il n'est pas nécessaire de graver la structure d'AlₓGa₁₋ₓAs oxydé (ou AlOx) à faible indice de réfraction. Celle-ci pourra toutefois être légèrement gravée pour être certain qu'il ne reste plus de couche de transition graduelle e2 pour réaliser ainsi une oxydation latérale optimale (par les surfaces A et B puis dans la couche d'épaisseur e0+e1).

Tandis que dans les structures monolithiques guide d'onde sur semi-conducteur décrites dans l'état de l'art (cf. figure 4a) le plus faible saut d'indice entre couches impose une plus grande épaisseur de couche isolante pour assurer le confinement de la lumière dans le guide d'onde. Une hauteur de gravure h_{gravée} (h_{gravée}=h_{etch}) supérieure à 2µm est donc nécessaire dans cette configuration imposant un rapport h_{gravée}/ g_{donné} de l'ordre de 40, très difficilement réalisable expérimentalement, pour conserver une situation de couplage optique (g_{donné} < 100 nm pour une longueur d'onde λ = 1,55 µm).

### EXEMPLE DE REALISATION

La première étape consiste en l'épitaxie par jets moléculaires d'une couche de 400 nm de Al_{0.18}Ga_{0.82}As au-dessus d'un substrat riche en aluminium, qu'on viendra oxyder ultérieurement, sur un wafer de GaAs [100] non-intentionnellement dopé. Afin d'améliorer l'adhésion finale entre le substrat d'AIOx et les milieux cristallins adjacents, ce substrat consiste d'une couche d'environ 1 µm d'Al_{0.98}Ga_{0.02}As placée entre deux régions de transitions ayant chacune une épaisseur de 90 nm, dont la fraction molaire d'AI diminue graduellement jusqu'à la fraction molaire d'AI des couches cristallines adjacentes. Ce choix, motivé par le fait que la cinétique d'oxydation varie de façon très sensible proportionnellement à la fraction molaire d'AI, est essentiel pour la réussite du procédé de fabrication.

Afin de réaliser le démonstrateur choisi à titre d'exemple, c'est-à-dire une matrice de nano-cylindres AIGaAs sur substrat d'AIOx, il a été dessiné par lithographie électronique des cercles avec des rayons allant de 180 nm à 220 nm, uniformément espacés de 3 µm.

Après le délaquage de la résine non exposée, l'échantillon a été soumis à une gravure sèche non sélective. La profondeur de gravure définit les nano-cylindres et révèle le substrat en Al_{0.98}Ga_{0.02}As (voir les figures 1).

Après la gravure sèche l'échantillon est placé en acétone pour le délaquage de la résine, après quoi il est nettoyé, séché et placé rapidement dans l'enceinte à vide du four d'oxydation.

L'oxydation se déroule à 390°C pendant 30 minutes.

Une démonstration d'un nano-émetteur de second harmonique a été réalisée en focalisant un faisceau de pompe infrarouge sur un de ces nano-cylindres (hauteur de 400 nm, rayon de 200 nm). Celui-ci rayonne un signal de second harmonique dans le visible, lorsque la longueur d'onde de la pompe est balayée autour de la résonance à 1200 nm (le faisceau de pompe est en incidence normale sur l'échantillon et le signal de second harmonique est collecté en réflexion).

Au-delà de cette première démonstration de nano-antenne optique bi-fréquence sur puce semiconductrice, il a été réalisé et testé des guides d'ondes AIGaAs/AIOx monolithiques basés sur le même procédé, pour établir un benchmark par rapport à ce qu'on trouve en littérature. Il a été mesuré des pertes optiques de 6dB/cm à 1,55 µm sur les tout premiers échantillons, pour des largeurs de guide de 3µm.

## Revendications

1. Procédé de fabrication d'au moins une structure (1) semi-conductrice présentant un empilement de n couches (2) semi-conductrices d'Arséniure de Gallium-Aluminium AlₓᵢGa₁₋ₓᵢAs, n étant un entier supérieur ou égal à 1 (et 1 ≤ i ≤ n), pour lesquelles xi est inférieur à 0.8,
sur une couche (3b) d'AlₓᵢGa₁₋ₓᵢAs oxydé isolante, qui a une épaisseur donnée e suffisante pour confiner la lumière dans la structure (1) semi conductrice par réflexion totale interne et qui sert de substrat optique à la structure (1) semi-conductrice, e étant supérieure à 200 nm et inférieure à 10 micromètres,
le procédé comprenant les étapes suivantes :
- dans une première étape (i), sur un substrat (4) de GaAs, croissance par épitaxie :
*d'une couche semi-conductrice AlₓGa₁₋ₓAs (3a), ayant une épaisseur e= e0 + e1+ e2, et comprenant une partie d'épaisseur e0, une partie d'épaisseur e1 et une partie d'épaisseur e2, la partie d'épaisseur e0 ayant une fraction molaire en aluminium x=x0 donnée supérieure ou égale à 0.90, la partie d'épaisseur e0 étant située entre la partie d'épaisseur e1 et la partie d'épaisseur e2,
*puis d'une ou plusieurs couches (2) semi-conductrices AlₓᵢGa₁₋ₓᵢAs,
la croissance par épitaxie de la première étape (i) étant réalisée de sorte à ce que la fraction molaire d'aluminium x de la couche semi-conductrice (3a) d'AlₓGa₁₋ₓAs diminue, à partir de la partie d'épaisseur e0, graduellement selon une variation progressive et continue :
dans la partie d'épaisseur e1, suivant un premier sens, selon un premier gradient d'aluminium (G1), de la fraction molaire en aluminium x0 donnée de la partie d'épaisseur e0 jusqu'à la fraction molaire d'aluminium x=0 du substrat (4) de GaAs, la partie d'épaisseur e1 étant en contact avec le substrat (4) et la partie d'épaisseur e0, et
dans la partie d'épaisseur e2, suivant un deuxième sens, opposé au premier sens, selon un deuxième gradient d'aluminium (G2), de la fraction molaire en aluminium x0 donnée de la partie d'épaisseur e0 jusqu'à la fraction molaire d'aluminium x=x1 avec x1 fraction molaire d'une première couche semi-conductrice Alₓ₁Ga₁₋ₓ₁As de l'empilement de n couches (2) semi-conductrices d'Arséniure de Gallium-Aluminium AlₓᵢGa₁₋ₓᵢAs, adjacente à la couche semi-conductrice AlₓᵢGa₁₋ₓᵢAs (3a), la partie d'épaisseur e2 étant en contact avec la partie d'épaisseur e0 et la couche Alₓ₁Ga₁₋ₓ₁As
- dans une deuxième étape (ii),
réalisation de la structure (1) semi-conductrice de couches (2) semi-conductrices d'AlₓᵢGa₁₋ₓᵢAs par lithographie et gravure, et
suppression par lithographie et gravure de la partie d'épaisseur e2 à gradient d'aluminium G2 de la couche semi-conductrice d'AlₓGa₁₋ₓAs (3a) sauf sous la structure (1) semi-conductrice ;
- dans une troisième étape (iii), oxydation latérale de la couche semi-conductrice (3a) d'AlₓGa₁₋ₓAs pour obtenir la couche (3b) d'AlₓGa₁₋ₓAs oxydé,
les couches semi-conductrices d'AlₓᵢGa₁₋ₓᵢAs de la structure (1) semi-conductrice, pour lesquelles xi est inférieur à 0.8, n'étant pas oxydées.

2. Procédé de fabrication selon la revendication précédente, **caractérisé en ce que** la couche (3b) d'AlₓGa₁₋ₓAs oxydé a une épaisseur e inférieure au micromètre.

3. Procédé de fabrication selon la revendication 1, **caractérisé en ce que** la couche (3b) d'AlₓGa₁₋ₓAs oxydé a une épaisseur e supérieure à 1 micromètre.

4. Procédé de fabrication selon la revendication précédente, dans lequel on réalise deux structures (1, 9, 10), couplées optiquement, ayant chacune une ou plusieurs couches semi-conductrices d'AlₓᵢGa₁₋ₓᵢAs empilées sur la couche (3b) d'AlₓGa₁₋ₓAs oxydé, les couches semi-conductrices d'AlₓᵢGa₁₋ₓᵢAs et la couche (3b) d'AlₓGa₁₋ₓAs oxydé étant gravées avec une hauteur de gravure h_{donnée} et un écart g_{donné} entre les deux structures gravées (9, 10), et dans lequel le rapport entre gravure h_{donnée} / g_{donné} est inférieur à 10, pour un écart g_{donné} inférieur à 100 nm.

5. Procédé de fabrication selon l'une des revendications précédentes, **caractérisé en ce que** le premier gradient d'aluminium (G1) est réalisé sur la partie d'épaisseur e1 entre 80 et 100 nm, pour éviter la délamination entre la couche (3b) d'AlₓGa₁₋ₓAs oxydé et le substrat (4) de GaAs.

6. Procédé de fabrication selon l'une des revendications précédentes, **caractérisé en ce que** le deuxième gradient d'aluminium (G2) est réalisé sur une épaisseur entre 80 et 100 nm, pour éviter la délamination entre la couche (3b) d'AlₓGa₁₋ₓAs oxydé et la première couche semi-conductrice AlₓGa₁₋ₓAs, ainsi que pour améliorer le confinement des ondes dans la structure (1) semi-conductrice AlₓᵢGa₁₋ₓᵢAs.

7. Procédé de fabrication selon l'une des revendications précédentes, **caractérisé en ce que** dans la troisième étape (iii), il y a également oxydation d'une ou plusieurs couches d'AlₓᵢGa₁₋ₓᵢAs dans la structure (1) semi-conductrice, ces couches d'AlₓᵢGaᵢ₋ₓᵢAs oxydé ayant une teneur en aluminium xi supérieure à 0,90.

8. Procédé de fabrication selon l'une des revendications précédentes, **caractérisé en ce que**, pour la couche semi-conductrice (3a) d'AlₓGa₁₋ₓAs, la fraction molaire est de x = 0.98 pour la partie d'épaisseur donnée e0, permettant de maximiser simultanément la cinétique d'oxydation et la tenue mécanique de ladite couche, tout en minimisant la température d'oxydation.

9. Procédé de fabrication selon l'une des revendications précédentes, **caractérisé en ce que** la température d'oxydation est choisie égale à 390° C.

10. Procédé de fabrication selon l'une des revendications précédentes, **caractérisé en ce que** la température d'oxydation est choisie égale ou inférieure à 390° C.

11. Procédé de fabrication selon l'une des revendications précédentes, **caractérisé en ce que**, dans la première étape (i), toute couche semi-conductrice que l'on souhaite oxyder est réalisée par un réseau équivalent d'alliages binaires AlAs/GaAs.

12. Procédé de fabrication selon l'une des revendications précédentes, **caractérisé en ce que** la structure (1) semi-conductrice est une micro- ou nano- structure optique active ou passive, tel qu'un guide d'onde, un résonateur, une antenne diélectrique, ou une combinaison d'une ou plusieurs de chacune de ces structures, éventuellement incorporant un laser ou un capteur optique à semi-conducteur.

13. Dispositif obtenu par le procédé de fabrication selon l'une des revendications précédentes 1-12 et comprenant un empilement monolithique avec :
- une structure (1) semi-conductrice de n couches (2) semi-conductrices d'Arséniure de Gallium-Aluminium AlₓᵢGa₁₋ₓᵢAs, n étant un entier supérieur ou égal à 1 (et 1 ≤ i ≤ n), sur une couche isolante d'AlₓᵢGa₁₋ₓᵢAs oxydé (3b) ;
la structure (1) semi-conductrice de couches (2) d'AlₓᵢGa₁₋ₓᵢAs comprenant une ou plusieurs couches semi-conductrices d'AlₓᵢGa₁₋ₓᵢAs de la structure (1) semi-conductrice qui ne sont pas oxydées et qui ont une teneur en aluminium xi inférieure à 0.8 ;
- la couche (3b) d'AlₓGa₁₋ₓAs oxydé ayant une épaisseur e suffisante pour confiner la lumière dans la structure (1) semi-conductrice par réflexion totale interne, servant de substrat optique à la structure (1) semi-conductrice et étant en appui sur un substrat (4) de GaAs, e étant supérieure à 200 nm et inférieure à 10 micromètres, et étant égale à la somme e=e0+ e1+ e2, la couche (3b) d'AlₓGa₁₋ₓAs oxydé comprenant une partie d'épaisseur e0, une partie d'épaisseur e1 et une partie d'épaisseur e2, la partie d'épaisseur e0 étant comprise entre la partie d'épaisseur e1 et la partie d'épaisseur e2,
la couche (3b) d'AlₓGa₁₋ₓAs oxydé présentant :
- une première transition d'oxydation graduelle correspondant à la partie d'épaisseur e1, située entre le substrat (4) de GaAs et la partie d'épaisseur e0 de la couche (3b) d'AlₓGa₁₋ₓAs oxydé, le degré d'oxydation diminuant dans la partie d'épaisseur e1 graduellement vers le substrat (4) de GaAs ;
- une deuxième transition d'oxydation graduelle correspondant à la partie d'épaisseur e2, située entre la partie d'épaisseur e0 de la couche (3b) d'AlₓGa₁₋ₓAs oxydé et une première couche semi-conductrice (2) Alₓ₁Ga₁₋ₓ₁As, le degré d'oxydation diminuant dans la partie d'épaisseur e2 graduellement vers la première couche semi-conductrice Alₓ₁Ga₁₋ₓ₁As de la structure (1) semi-conductrice.

14. Dispositif selon la revendication 13, dans lequel la couche d'AlₓGa₁₋ₓAs oxydé a une épaisseur donnée e supérieure à 1 micromètre.

15. Dispositif selon la revendication 13, dans lequel la couche d'AlₓGa₁₋ₓAs oxydé a une épaisseur donnée e inférieure à 1 micromètre.

16. Dispositif selon l'une des revendications 13 à 15, avec deux structures (1, 9, 10), couplées optiquement et ayant une ou plusieurs couches semi-conductrices d'AlₓᵢGa₁₋ₓᵢAs chacune, empilées sur la couche (3b) d'AlₓGa₁₋ₓAs oxydé,
les couches semi-conductrices d'AlxiGa1-xiAs et la couche (3b) d'AlₓGa₁₋ₓAs oxydé étant gravées avec une hauteur de gravure h_{donnée} et un écart g_{donné} entre les deux structures (1),
le rapport entre h_{donnée} / g_{donné} étant inférieur à 10, pour un écart g_{donné} inférieur à 100 nm.

17. Dispositif selon l'une des revendications 13 à 16, dans lequel la couche d' AlₓGa₁₋ₓAs oxydé a un indice de réfraction égal à 1,6.

18. Dispositif selon l'une des revendications 13 à 17, dans lequel la structure (1) semi-conductrice est une micro/nano structure optique active ou passive, tel un guide d'onde, un résonateur, une antenne diélectrique, ou une combinaison d'un ou plusieurs de chacune de ces structures.

19. Dispositif selon l'une des revendications 13 à 18, dans lequel la structure (1) semi-conductrice présente également une ou plusieurs couches d'AlₓᵢGa₁₋ₓᵢAs oxydé avec xi≥0.9.

20. Dispositif selon l'une des revendications 13 à 19, dans lequel la structure (1) semi-conductrice incorpore un laser ou un capteur optique à semiconducteur.

21. Dispositif selon l'une des revendications 13 à 20, dans lequel la structure (1) semi-conductrice a la forme d'une ou de plusieurs antennes diélectriques qui rayonnent avec un signal de seconde harmonique.

## Patentansprüche

1. Verfahren zur Herstellung von mindestens einer Halbleiterstruktur (1) mit einem Stapel von n Halbleiterschichten (2) aus Aluminiumgalliumarsenid AlₓᵢGa₁₋ₓᵢAs, wobei n eine ganze Zahl größer als oder gleich 1 ist (und 1 • i • n), für die xi kleiner als 0,8 ist,
auf einer Schicht (3b) aus isolierendem oxidiertem AlₓᵢGa₁₋ₓᵢAs, die eine gegebene Dicke e aufweist, die ausreicht, um das Licht in der Halbleiterstruktur (1) durch innere Totalreflexion einzuschließen, und die als optisches Substrat für die Halbleiterstruktur (1) dient, wobei e größer als 200 nm und kleiner als 10 Mikrometer ist,
wobei das Verfahren die folgenden Schritte umfasst:
- in einem ersten Schritt (i) auf einem Substrat (4) aus GaAs, Wachstum durch Epitaxie: *einer AlₓGa₁₋ₓAs-Halbleiterschicht (3a) mit einer Dicke e = e0 + e1 + e2 und die einen Teil der Dicke e0, einen Teil der Dicke e1 und einen Teil der Dicke e2 umfasst, wobei der Teil der Dicke e0 einen gegebenen Aluminium-Stoffmengenanteil x = x0 größer als oder gleich 0,90 aufweist, wobei der Teil der Dicke e0 zwischen dem Teil der Dicke e1 und dem Teil der Dicke e2 liegt, *dann einer oder mehrerer AlₓᵢGa₁₋ₓᵢAs-Halbleiterschichten (2),
wobei das Wachstum durch Epitaxie des ersten Schritts (i) so durchgeführt wird, dass der Stoffmengenanteil von Aluminium x der Halbleiterschicht (3a) aus AlₓGa₁₋ₓAs ausgehend von dem Teil der Dicke e0 allmählich entsprechend einer progressiven und kontinuierlichen Veränderung abnimmt:
im Teil der Dicke e1 in einer ersten Richtung gemäß einem ersten Aluminiumgradienten (G1) von dem Stoffmengenanteil von Aluminium x0, der von dem Teil der Dicke e0 gegeben ist, bis zu dem Stoffmengenanteil von Aluminium x = 0 des GaAs-Substrats (4), wobei der Teil der Dicke e1 in Kontakt mit dem Substrat (4) und dem Teil der Dicke e0 ist, und
im Teil der Dicke e2 in einer zweiten Richtung entgegengesetzt zur ersten Richtung gemäß einem zweiten Aluminiumgradienten (G2) von dem Stoffmengenanteil von Aluminium x0, der von dem Teil der Dicke e0 gegeben ist, bis zu dem Stoffmengenanteil von Aluminium x = x1 mit x1 Stoffmengenanteil einer ersten Alₓ₁Ga₁₋ₓ₁As-Halbleiterschicht des Stapels aus n Halbleiterschichten (2) aus Aluminiumgalliumarsenid AlₓᵢGa₋₁₋ₓᵢAs, die an die AlₓᵢGa₁₋ₓᵢAs-Halbleiterschicht (3a) angrenzt, wobei der Teil der Dicke e2 in Kontakt mit dem Teil der Dicke e0 und der Alₓ₁Ga₁₋ₓ₁As-Schicht ist
- in einem zweiten Schritt (ii),
Herstellen der Halbleiterstruktur (1) aus Halbleiterschichten (2) aus AlₓᵢGa₁₋ₓᵢAs durch Lithographie und Ätzen, und
Eliminieren durch Lithographie und Ätzen des Teils der Dicke e2 mit einem Aluminiumgradienten G2 der Halbleiterschicht aus AlₓGa₁₋ₓAs (3a), außer unter der Halbleiterstruktur (1);
- in einem dritten Schritt (iii), laterales Oxidieren der Halbleiterschicht (3a) aus AlₓGa₁₋ₓAs, um die Schicht (3b) aus oxidiertem AlₓGa₁₋ₓAs zu erhalten,
wobei die Halbleiterschichten aus AlₓᵢGa₁₋ₓᵢAs der Halbleiterstruktur (1), für die xi kleiner als 0,8 ist, nicht oxidiert sind.

2. Herstellungsverfahren nach dem vorhergehenden Anspruch, **dadurch gekennzeichnet, dass** die Schicht (3b) aus oxidiertem AlₓGa₁₋ₓAs eine Dicke e von weniger als einem Mikrometer aufweist.

3. Herstellungsverfahren nach Anspruch 1, **dadurch gekennzeichnet, dass** die Schicht (3b) aus oxidiertem AlₓGa₁₋ₓAs eine Dicke e von mehr als 1 Mikrometer aufweist.

4. Herstellungsverfahren nach dem vorhergehenden Anspruch, bei dem zwei optisch gekoppelte Strukturen (1, 9, 10) hergestellt werden, die jeweils eine oder mehrere Halbleiterschichten aus AlₓᵢGa₁₋ₓᵢAs aufweisen, die auf der Schicht (3b) aus oxidiertem AlₓGa₁₋ₓAs gestapelt sind, wobei die Halbleiterschichten aus AlₓᵢGa₁₋ₓᵢAs und die Schicht (3b) aus oxidiertem AlₓGa₁₋ₓAs mit einer Ätzhöhe h_{gegeben} und einem Abstand g_{gegeben} zwischen den beiden geätzten Strukturen (9, 10) geätzt sind, und bei dem das Verhältnis zwischen Ätzen h_{gegeben}/g_{gegeben} kleiner als 10 ist für einen Abstand g_{gegeben} kleiner als 100 nm.

5. Herstellungsverfahren nach einem der vorhergehenden Ansprüche, **dadurch gekennzeichnet, dass** der erste Aluminiumgradient (G1) auf dem Teil mit einer Dicke e1 zwischen 80 und 100 nm erzeugt wird, um eine Delaminierung zwischen der Schicht (3b) aus oxidiertem AlₓGa₁₋ₓAs und dem Substrat (4) aus GaAs zu vermeiden.

6. Herstellungsverfahren nach einem der vorhergehenden Ansprüche, **dadurch gekennzeichnet, dass** der zweite Aluminiumgradient (G2) über eine Dicke zwischen 80 und 100 nm erzeugt wird, um eine Delaminierung zwischen der Schicht (3b) aus oxidiertem AlₓGa₁₋ₓAs und der ersten AlₓGa₁₋ₓAs-Halbleiterschicht zu vermeiden und um den Welleneinschluss in der AlₓᵢGa₁₋ₓᵢAs-Halbleiterstruktur (1) zu verbessern.

7. Herstellungsverfahren nach einem der vorhergehenden Ansprüche, **dadurch gekennzeichnet, dass** im dritten Schritt (iii) auch eine Oxidation einer oder mehrerer Schichten aus AlₓᵢGa₁₋ₓᵢAs in der Halbleiterstruktur (1) stattfindet, wobei diese Schichten aus oxidiertem AlₓᵢGa₁₋ₓᵢAs einen Aluminiumgehalt xi größer als 0,90 aufweisen.

8. Herstellungsverfahren nach einem der vorhergehenden Ansprüche, **dadurch gekennzeichnet, dass** für die Halbleiterschicht (3a) aus AlₓGa₁₋ₓAs der Stoffmengenanteil für den Teil mit gegebener Dicke e0 x = 0,98 ist, wodurch gleichzeitig die Oxidationskinetik und die mechanische Festigkeit der Schicht maximiert werden kann, während die Oxidationstemperatur minimiert wird.

9. Herstellungsverfahren nach einem der vorhergehenden Ansprüche, **dadurch gekennzeichnet, dass** die Oxidationstemperatur gleich 390 °C gewählt wird.

10. Herstellungsverfahren nach einem der vorhergehenden Ansprüche, **dadurch gekennzeichnet, dass** die Oxidationstemperatur gleich oder kleiner als 390 °C gewählt wird.

11. Herstellungsverfahren nach einem der vorhergehenden Ansprüche, **dadurch gekennzeichnet, dass** im ersten Schritt (i) jede gegebenenfalls zu oxidierende Halbleiterschicht durch ein äquivalentes Netzwerk aus binären AlAs/GaAs-Legierungen erzeugt wird.

12. Herstellungsverfahren nach einem der vorhergehenden Ansprüche, **dadurch gekennzeichnet, dass** die Halbleiterstruktur (1) eine aktive oder passive optische Mikro- oder Nanostruktur ist, wie ein Wellenleiter, ein Resonator, eine dielektrische Antenne oder eine Kombination aus einem oder mehreren von jeder dieser Strukturen ist, die gegebenenfalls einen Laser oder einen optischen Halbleitersensor enthält.

13. Vorrichtung, die durch das Herstellungsverfahren nach einem der vorhergehenden Ansprüche 1-12 erhalten wird und einen monolithischen Stapel umfasst mit:
- einer Halbleiterstruktur (1) aus n Halbleiterschichten (2) aus Aluminiumgalliumarsenid AlₓᵢGa₁₋ₓᵢAs, wobei n eine ganze Zahl größer oder gleich 1 ist (und 1 • i • n), auf einer Isolierschicht aus oxidiertem AlₓᵢGa₁₋ₓᵢAs (3b);
wobei die Halbleiterstruktur (1) aus Schichten (2) aus AlₓᵢGa₁₋ₓᵢAs eine oder mehrere Halbleiterschichten aus AlₓᵢGa₁₋ₓᵢAs der Halbleiterstruktur (1) umfasst, die nicht oxidiert sind und die einen Aluminiumgehalt xi von weniger als 0,8 aufweisen;
- wobei die Schicht (3b) aus oxidiertem AlₓGa₁₋ₓAs eine Dicke e aufweist, die ausreicht, um das Licht in der Halbleiterstruktur (1) durch innere Totalreflexion einzuschließen, die als optisches Substrat für die Halbleiterstruktur (1) dient und auf einem Substrat (4) aus GaAs liegt, wobei e größer als 200 nm und kleiner als 10 Mikrometer ist und gleich der Summe e = e0 + e1 + e2 ist, wobei die Schicht (3b) aus oxidiertem AlₓGa₁₋ₓAs einen Teil der Dicke e0, einen Teil der Dicke e1 und einen Teil der Dicke e2 umfasst, wobei der Teil der Dicke e0 zwischen dem Teil der Dicke e1 und dem Teil der Dicke e2 liegt,
wobei die Schicht (3b) aus oxidiertem AlₓGa₁₋ₓAs aufweist:
- einen ersten allmählichen Oxidationsübergang, der dem Teil der Dicke e1 entspricht, der sich zwischen dem Substrat (4) aus GaAs und dem Teil der Dicke e0 der Schicht (3b) aus oxidiertem AlₓGa₁₋ₓAs befindet, wobei der Oxidationsgrad in dem Teil der Dicke e1 in Richtung des Substrats (4) aus GaAs allmählich abnimmt;
- einen zweiten allmählichen Oxidationsübergang, der dem Teil der Dicke e2 entspricht, der sich zwischen dem Teil der Dicke e0 der Schicht (3b) aus oxidiertem AlₓGa₁₋ₓAs und einer ersten Alₓ₁Ga₁₋ₓ₁As-Halbleiterschicht (2) befindet, wobei der Oxidationsgrad in dem Teil der Dicke e2 allmählich in Richtung der ersten Alₓ₁Ga₁₋ₓ₁As-Halbleiterschicht der Halbleiterstruktur (1) abnimmt.

14. Vorrichtung nach Anspruch 13, bei der die Schicht aus oxidiertem AlₓGa₁₋ₓAs eine gegebene Dicke e größer als 1 Mikrometer aufweist.

15. Vorrichtung nach Anspruch 13, bei der die Schicht aus oxidiertem AlₓGa₁₋ₓAs eine gegebene Dicke e von weniger als 1 Mikrometer aufweist.

16. Vorrichtung nach einem der Ansprüche 13 bis 15, mit zwei optisch gekoppelten Strukturen (1, 9, 10) und mit jeweils einer oder mehreren Halbleiterschichten aus AlₓᵢGa₁₋ₓᵢAs, die auf der Schicht (3b) aus oxidiertem AlₓGa₁₋ₓAs gestapelt sind,
wobei die Halbleiterschichten aus AlₓᵢGa₁₋ₓᵢAs und die Schicht (3b) aus oxidiertem AlₓGa₁₋ₓAs mit einer Ätzhöhe h_{gegeben} und einem Abstand g_{gegeben} zwischen den beiden Strukturen (1) geätzt sind,
wobei das Verhältnis zwischen h_{gegeben}/g_{gegeben} kleiner als 10 ist, für einen Abstand g_{gegeben} kleiner als 100 nm.

17. Vorrichtung nach einem der Ansprüche 13 bis 16, bei der die Schicht aus oxidiertem AlₓGa₁₋ₓAs einen Brechungsindex gleich 1,6 aufweist.

18. Vorrichtung nach einem der Ansprüche 13 bis 17, bei der die Halbleiterstruktur (1) eine aktive oder passive optische Mikro-/Nanostruktur wie ein Wellenleiter, ein Resonator, eine dielektrische Antenne oder eine Kombination aus einer oder mehreren dieser Strukturen ist.

19. Vorrichtung nach einem der Ansprüche 13 bis 18, bei der die Halbleiterstruktur (1) auch eine oder mehrere Schichten aus oxidiertem AlₓᵢGa₁₋ₓᵢAs mit xi • 0,9 aufweist.

20. Vorrichtung nach einem der Ansprüche 13 bis 19, bei der die Halbleiterstruktur (1) einen Laser oder einen optischen Halbleitersensor enthält.

21. Vorrichtung nach einem der Ansprüche 13 bis 20, bei der die Halbleiterstruktur (1) die Form einer oder mehrerer dielektrischer Antennen hat, die mit einem zweiten Oberwellensignal strahlen.

## Claims

1. A method for manufacturing at least one semiconducting structure (1) having a stack of n Aluminium Gallium Arsenide AlₓᵢGa₁₋ₓᵢAs semiconducting layers (2), n being an integer greater than or equal to 1 (and 1 • i • n), for which xi is less than 0.8,
on a layer (3b) of insulating oxidised AlₓᵢGa₁₋ₓᵢAs, which has a given thickness e sufficient to confine the light in the semiconducting structure (1) by total internal reflection and which serves as an optical substrate for the semiconducting structure (1), e being greater than 200 nm and less than 10 micrometres,
the method comprising the following steps:
- in a first step (i), on a substrate (4) of GaAs, growth by epitaxy: *of a semiconducting layer AlₓGa₁₋ₓAs (3a), having a thickness e= e0 + e1 + e2, and comprising a part of thickness e0, a part of thickness e1 and a part of thickness e2, the part of thickness e0 having a given aluminium molar fraction x=x0 greater than or equal to 0.90, the part of thickness e0 being located between the part of thickness e1 and the part of thickness e2,
*then one or more AlₓᵢGa₁₋ₓᵢAs semiconducting layers (2),
the growth by epitaxy of the first step (i) being carried out so that the molar fraction of aluminium x of the semiconducting layer (3a) of AlₓGa₁₋ₓAs decreases, starting from the part of thickness e0, gradually according to a progressive and continuous variation:
in the part of thickness e1, in a first direction, according to a first gradient of aluminium (G1), from the given molar fraction of aluminium x0 of the part of thickness e0 to the molar fraction of aluminium x=0 of the GaAs substrate (4), the part of thickness e1 being in contact with the substrate (4) and the part of thickness e0, and
in the part of thickness e2, in a second direction, opposite to the first direction, according to a second aluminium gradient (G2), from the given molar fraction of aluminium x0 of the part of thickness e0 to the molar fraction of aluminium x=x1, with x1 the molar fraction of a first semiconducting layer Alₓ₁Ga₁₋ₓ₁As of the stack of n Aluminium Gallium Arsenide AlₓᵢGa₋₁₋ₓᵢAs semiconducting layers (2), adjacent to the semiconducting layer AlₓᵢGa₁₋ₓᵢAs (3a), the part of thickness e2 being in contact with the part of thickness e0 and the layer Alₓ₁Ga₁₋ₓ₁As
- in a second step (ii),
producing the semiconducting structure (1) of semiconducting layers (2) of AlₓᵢGa₁₋ₓᵢAs by lithography and etching, and
removing, by lithography and etching, the part of thickness e2 with an aluminium gradient G2 of the semiconducting layer (3a) of AlₓGa₁₋ₓAs, except under the semiconducting structure (1);
- in a third step (iii), lateral oxidation of the semiconducting layer (3a) of AlₓGa₁₋ₓAs to obtain the layer (3b) of oxidised AlₓGa₁₋ₓAs,
the semiconducting layers of AlₓᵢGa₁₋ₓᵢAs of the semiconducting structure (1), for which xi is less than 0.8, not being oxidised.

2. The manufacturing method according to the preceding claim, **characterised in that** the layer (3b) of oxidised AlₓGa₁₋ₓAs has a thickness e of less than one micrometre.

3. The manufacturing method according to Claim 1, **characterised in that** the layer (3b) of oxidised AlₓGa₁₋ₓAs has a thickness e greater than 1 micrometre.

4. The manufacturing method according to the preceding claim, in which two optically coupled structures (1, 9, 10) are produced, each having one or more semiconducting layers of AlₓᵢGa₁₋ₓᵢAs stacked on the layer (3b) of oxidised AlₓGa₁₋ₓAs, the semiconducting layers of AlₓᵢGa₁₋ₓᵢAs and the layer (3b) of oxidised AlₓGa₁₋ₓAs being etched with an etching height h_{given} and a gap g_{given} between the two etched structures (9, 10), and in which the ratio between etching h_{given}/g_{given} is less than 10, for a gap g_{given} less than 100 nm.

5. The manufacturing method according to one of the preceding claims, **characterised in that** the first aluminium gradient (G1) is produced on the part of thickness e1 between 80 and 100 nm, to avoid delamination between the layer (3b) of oxidised AlₓGa₁₋ₓAs and the substrate (4) of GaAs.

6. The manufacturing method according to one of the preceding claims, **characterised in that** the second aluminium gradient (G2) is produced over a thickness between 80 and 100 nm, to avoid delamination between the layer (3b) of oxidised AlₓGa₁₋ₓAs and the first AlₓGa₁₋ₓAs semiconducting layer, as well as to improve the wave confinement in the AlₓᵢGa₁₋ₓᵢAs semiconducting structure (1).

7. The manufacturing method according to one of the preceding claims, **characterised in that** in the third step (iii), there is also oxidation of one or more layers of AlₓᵢGa₁₋ₓᵢAs in the semiconducting structure (1), said layers of oxidised AₓᵢGa₁₋ₓᵢAs having an aluminium content xi greater than 0.90.

8. The manufacturing method according to one of the preceding claims, **characterised in that**, for the semiconducting layer (3a) of AlₓGa₁₋ₓAs, the molar fraction is x = 0.98 for the part of given thickness e0, making it possible to simultaneously maximise the oxidation kinetics and the mechanical strength of said layer, while minimising the oxidation temperature.

9. The manufacturing method according to one of the preceding claims, **characterised in that** the oxidation temperature is chosen to be equal to 390°C.

10. The manufacturing method according to one of the preceding claims, **characterised in that** the oxidation temperature is chosen to be lower than or equal to 390°C.

11. The manufacturing method according to one of the preceding claims, **characterised in that**, in the first step (i), any semiconducting layer to be oxidised is produced by an equivalent network of AlAs/GaAs binary alloys.

12. The manufacturing method according to one of the preceding claims, **characterised in that** the semiconducting structure (1) is an active or passive optical micro- or nano-structure, such as a wave guide, a resonator, an antenna dielectric, or a combination of one or more of each of these structures, optionally incorporating a laser or a semiconducting optical sensor.

13. A device obtained by the manufacturing method according to one of the preceding claims 1-12 and comprising a monolithic stack having:
- a semiconducting structure (1) of n Aluminium Gallium Arsenide AlₓᵢGa₁₋ₓᵢAs semiconducting layers (2), n being an integer greater than or equal to 1 (and 1 • i • n), on an insulating layer (3b) of oxidised AlₓᵢGa₁₋ₓᵢAs;
the semiconducting structure (1) of AlₓᵢGa₁₋ₓᵢAs layers (2) comprising one or more AlₓᵢGa₁₋ₓᵢAs semiconducting layers of the semiconducting structure (1), which are not oxidised and which have an aluminium content xi of less than 0.8;
- the layer (3b) of oxidised AlₓGa₁₋ₓAs having a thickness e sufficient to confine the light in the semiconducting structure (1) by total internal reflection, serving as an optical substrate for the semiconducting structure (1) and resting on a substrate (4) of GaAs, e being greater than 200 nm and less than 10 micrometres, and being equal to the sum e=e0+e1+e2, the layer (3b) of oxidised AlₓGa₁₋ₓAs comprising a part of thickness e0, a part of thickness e1 and a part of thickness e2, the part of thickness e0 being between the part of thickness e1 and the part of thickness e2,
the layer (3b) of oxidised AlₓGa₁₋ₓAs having:
- a first gradual oxidation transition corresponding to the part of thickness e1, located between the substrate (4) of GaAs and the part of thickness e0 of the layer (3b) of oxidised AlₓGa₁₋ₓAs, the degree of oxidation gradually decreasing in the part of thickness e1 towards the substrate (4) of GaAs;
- a second gradual oxidation transition corresponding to the part of thickness e2, located between the part of thickness e0 of the layer (3b) of oxidised AlₓGa₁₋ₓAs and a first Alₓ₁Ga₁₋ₓ₁As semiconducting layer (2), the degree of oxidation gradually decreasing in the part of thickness e2 towards the first Alₓ₁Ga₁₋ₓ₁As semiconducting layer of the semiconducting structure (1).

14. The device according to claim 13, in which the layer of oxidised AlₓGa₁₋ₓAs has a given thickness e greater than 1 micrometre.

15. The device according to claim 13, in which the layer of oxidised AlₓGa₁₋ₓAs has a given thickness e less than 1 micrometre.

16. The device according to one of claims 13 to 15, with two structures (1, 9, 10), optically coupled and each having one or more semiconducting layers of AlₓᵢGa₁₋ₓᵢAs stacked on the layer (3b) of oxidised AlₓGa₁₋ₓAs,
the semiconducting layers of AlₓᵢGa₁₋ₓᵢAs and the layer (3b) of oxidised AlₓGa₁₋ₓAs being etched with an etching height h_{give}, and a gap g_{given} between the two structures (1),
the ratio between h_{given}/g_{given} being less than 10, for a gap g_{given} less than 100 nm.

17. The device according to one of claims 13 to 16, in which the layer of oxidised AlₓGa₁₋ₓAs has a refractive index equal to 1.6.

18. The device according to one of claims 13 to 17, in which the semiconducting structure (1) is an active or passive optical micro/nano structure, such as a wave guide, a resonator, a dielectric antenna, or a combination of one or more of each of these structures.

19. The device according to one of claims 13 to 18, in which the semiconducting structure (1) also has one or more layers of oxidised AlₓᵢGa₁₋ₓᵢAs with xi•0.9.

20. The device according to one of claims 13 to 19, in which the semiconducting structure (1) incorporates a laser or a semiconducting optical sensor.

21. The device according to one of claims 13 to 20, in which the semiconducting structure (1) has the form of one or more dielectric antennae that radiate with a second harmonic signal.
